# FASCICULE DE BREVET EUROPEEN

(11) **EP 2 994 965 B1**
(45) Date de publication et mention de la délivrance du brevet: **28.09.2016**
(21) Numéro de dépôt: 14729398.9
(22) Date de dépôt: 07.05.2014
(51) Int. Cl.: H02G 3/04

(54) **GAINE DE PROTECTION D'UN HARNAIS ÉLECTRIQUE AFIN DE PRÉVENIR SA DÉTÉRIORATION**
SCHUTZHÜLLE FÜR EINEN ELEKTRISCHEN KABELBAUM ZUR VERHINDERUNG DES VERSCHLEISSES DAVON
PROTECTIVE SHEATH FOR AN ELECTRICAL HARNESS IN ORDER TO PREVENT THE DETERIORATION OF SAME

(30) Priorité: 07.05.2013 FR 1354161
(43) Date de publication de la demande: 16.03.2016
(73) Titulaire: LABINAL POWER SYSTEMS, 31700 Blagnac (FR)
(72) Inventeur: GENOULAZ, Jérôme, F-31840 Seilh (FR); BRENDLE, Stéphane, 31700 Blagnac (FR); DUNAND, Michel, F-31130 Balma (FR)
(74) Mandataire: Regimbeau
(86) Numéro de dépôt international: PCT/FR2014/051067
(87) Numéro de publication internationale: WO 2014/181065

(56) Documents cités:
- GB-A- 1 037 071
- GB-A- 1 228 164
- US-B1- 6 265 880

## Description

### DOMAINE DE L'INVENTION

La présente invention concerne la prévention de la détérioration de câbles, notamment des câbles électrique, et plus particulièrement un dispositif et procédé de surveillance permettant de détecter une possible détérioration des câbles.

### ETAT DE LA TECHNIQUE

Il y a aujourd'hui encore de nombreuses applications et installations qui nécessitent l'utilisation de câbles, en particulier de câbles électriques, pour assurer leur fonctionnement. Ces câbles sont soumis à des contraintes, plus ou moins importantes, qui, ajoutées à l'usure naturelle, peuvent les détériorer au point d'entrainer des disfonctionnements, voire même d'empêcher leur fonctionnement.

Dans certaines applications spécifiques, telles que par exemple l'automobile, l'aéronautique, le naval, plusieurs câbles électriques sont généralement regroupés en faisceaux pour former des harnais. Un harnais regroupe donc un ensemble de conducteurs électriques destinés à relier électriquement entre eux les différents équipements d'une installation électrique complexe, dont le bon fonctionnement doit être assuré.

De manière générale, cet ensemble de câbles formant le harnais est entouré d'une gaine de protection. Outre le fait de maintenir les câbles ensembles, ces gaines peuvent offrir une protection mécanique, une protection incendie et/ou une protection électromagnétique. Dans le cas de la protection électromagnétique, comme par exemple à bord des aéronefs ou à bord des navires, il est primordial que l'installation électrique qu'interconnecte le harnais électrique fonctionne correctement même en cas de perturbations électromagnétiques, telles qu'une perturbation foudre. Même si chaque conducteur électrique comprend en général sa propre gaine isolante pouvant en outre comprendre un blindage complémentaire de protection contre les perturbations électromagnétiques, il est préférable que le harnais comprenne lui-même une gaine de protection contre les perturbations électromagnétiques. Cette gaine est en particulier nécessaire lorsque le harnais est trop proche d'un autre harnais sensible, ou lorsque l'on souhaite assurer une protection foudre ou champ fort. Ainsi, l'ensemble des câbles électriques formant le harnais peut par exemple être entouré d'une gaine de blindage métallique, obtenue généralement par tressage de fils métalliques, qui assure la continuité électrique entre les boîtiers des équipements via le raccordement du blindage aux connecteurs situés aux extrémités du harnais.

Toutefois, malgré ces gaines, les harnais peuvent subir différentes agressions selon l'environnement dans lequel ils sont placés. Une détérioration des câbles électriques formant le harnais peut par exemple être due à des contraintes mécaniques, tel qu'un écrasement, un pincement, une élongation, un choc ou toute usure par frottement. La détérioration peut également être due à des phénomènes externes, telles que des agressions par fluides, des agressions chimiques, ou encore par le feu.

De telles contraintes ou agressions peuvent entraîner une dégradation des isolants et/ou dès âmes des conducteurs électriques contenu dans les harnais, pouvant avoir des conséquences plus ou moins importantes dans le fonctionnement général de l'installation électrique. Outre les détériorations mineures créant des défauts dans les conducteurs pouvant entrainer des disfonctionnements, ces dégradations peuvent engendrer des défauts beaucoup plus importants avec des conséquences associées majeures.

Par exemple, de tels défauts peuvent à terme créer un circuit ouvert engendrant si le circuit est dans une phase fonctionnelle et selon le système connecté, au moment de l'ouverture du circuit, un arc électrique, puis dans tous les cas une perte de donnée ou une perte d'alimentation d'un équipement selon que le câble considéré est un câble de donnée ou un câble d'alimentation. Un défaut majeur peut également entrainer un court-circuit non franc entre deux ou plusieurs systèmes ou entre deux ou plusieurs conducteurs du même système pouvant engendrer un arc électrique.

Dans le cas d'un circuit ouvert, le système connecté est alors défaillant. C'est souvent dans un premier temps l'équipement qui est mis en cause et remplacé. Si l'équipement ne fonctionne toujours pas, on incrimine alors le câble. Le temps d'immobilisation du système peut être alors chronophage et très couteux.

Dans le cas d'un court-circuit, l'énergie de l'arc créé peut être importante, notamment dans le cas d'un câble de puissance. Les câbles voisins ainsi que les structures proches peuvent alors être endommagés à leur tour. Il faut alors non seulement changer le câble sur lequel est apparu le premier défaut mais également ceux qui ont subi des dégradations dues à l'élévation de.température (plasma chaud), aux rayonnements électromagnétiques (UV jusqu'à infrarouges), à la projection de matière (matériaux liquéfiés soumis aux forces de LAPLACE) créés lors de l'évolution de l'arc électrique. Les structures voisines peuvent également subir des dégradations graves nécessitant un remplacement ou une réparation.

Pour réduire le risque d'apparition de telles conséquences, il a par exemple été proposé d'utiliser des disjoncteurs à détection d'arc prévus pour couper la ligne électrique lorsque le conducteur entre en court-circuit et produit un arc. Leur utilisation pose toutefois un certain nombre de problèmes. Ils ne protègent en effet qu'en partie les câbles avoisinants et les structures car l'arc n'est détecté qu'à partir du moment où il existe, le défaut ne pouvant pas être anticipé et dans ce cas ne peut non plus prévenir la dégradation des structures et câbles voisins. Par ailleurs, les disjoncteurs détectent les courts-circuits mais pas les circuits ouverts car non associés à une décharge. Si le frottement sur une structure voisine entraîne la rupture d'un conducteur, alors ce défaut ne sera pas détecté par le disjoncteur. Enfin, si un disjoncteur peut s'installer sur un câble d'alimentation, il ne peut être employé pour les câbles de données.

Il est donc important de pouvoir anticiper l'apparition de défauts sur les câbles formant le harnais, pour éviter tout disfonctionnement majeur. En outre une telle anticipation de l'apparition des défauts sur les câbles pourrait réduire considérablement le coût de maintenance et assurer un taux de disponibilité plus important. En effet la maintenance du dispositif de protection / détection est alors plus simplement réalisable que le changement d'un ou plusieurs conducteurs.

Dans le brevet US 6,265,880, il a été proposé une solution pour anticiper l'apparition des défauts dans un câble électrique. Cette solution consiste à enrouler autour du conducteur un élément de détection (tel que par exemple un fil conducteur ou un câble à fibre optique) positionné sur le conducteur de sorte à être endommagé avant le conducteur, par frottement par exemple, et permettant ainsi de détecter une détérioration potentielle à venir du conducteur. Cette solution pose toutefois plusieurs problèmes. En effet, outre l'élément de détection en tant que tel, il est nécessaire de prévoir un élément de maintien en position de cet élément de détection, pour qu'il ne puisse pas bouger par rapport au conducteur, notamment en cas de vibrations trop importantes. Ainsi, le poids du câble à surveiller est sensiblement augmenté ce qui peut être très pénalisant. En outre un tel élément de maintien ne garantit pas que l'élément de détection ne va absolument pas bouger. Or, si l'élément de détection venait à se déplacer par rapport au conducteur, certaines portions du conducteur ne seraient plus surveillées, nuisant ainsi à l'efficacité de la solution. L'élément étant plus ou moins souple il peut lui-même être repoussé par l'action provoquant le défaut comme par exemple un frottement ou l'action d'une pointe et ainsi ne plus assurer la protection à l'endroit voulu. Enfin, une telle solution est assez complexe à mettre en oeuvre, nécessitant des moyens spécifiques pour la mise en place de l'élément de détection autour du câble, ainsi que pour la mise en place d'un élément de maintien en position adapté. Cette solution sera en particulier très difficile à mettre en oeuvre pour prévenir l'apparition de défauts dans un harnais comprenant plusieurs câbles regroupés ensemble. En effet, appliquer la solution proposée dans le brevet US 6,265,880 au cas des harnais multifilaires reviendrait à devoir entourer individuellement chaque conducteur électrique formant le harnais par un élément de détection spécifique. Les conséquences en termes de masse embarquée et en coûts, notamment de fabrication, ne sont pas acceptables.

Un but de la présente invention est donc de proposer un dispositif et un procédé de prédiction de défauts dans un harnais formé par une pluralité de câbles regroupés ensemble, en particulier des câbles électriques, qui permettent de résoudre au moins l'un des inconvénients précités.

En particulier, un but de la présente invention est de proposer un dispositif et un procédé de prédiction de défauts dans un harnais qui est simple à mettre en oeuvre, en particulier dont le positionnement par rapport au harnais ne vient pas complexifier la fabrication dudit harnais.

Encore un autre but de la présente invention est de proposer un dispositif et un procédé de prédiction de défauts dans un harnais qui ne modifie pas, ou peu, les caractéristiques intrinsèques du harnais, et ne vient en particulier pas gêner son fonctionnement, ni alourdir son poids.

### EXPOSE DE L'INVENTION

A cette fin, on propose un dispositif de prédiction de défauts dans un harnais formé par une pluralité de câbles regroupés ensemble, en particulier des câbles électriques, comprenant une gaine de protection destinée à entourer le harnais, la gaine comprenant une pluralité d'éléments de tressage, lesdits éléments de tressage étant tressés ensemble pour former une gaine tubulaire, chaque élément de tressage comprenant une pluralité de brins de tressage longitudinaux agencés pour former une nappe, caractérisé en ce que la gaine comprend au moins un brin de détection conducteur électriquement, ledit brin de détection étant agencé avec les brins de tressage d'un élément de tressage pour être intégré à la nappe formant ledit élément de tressage, le brin de détection étant isolé électriquement des brins de tressage dudit l'élément de tressage.

Des aspects préférés mais non limitatifs de cette gaine de protection, pris seuls ou en combinaison, sont les suivants :
- la gaine comprend une pluralité de brins de détection, les brins de détection étant isolés électriquement les uns des autres.
- les brins de détection sont intégrés dans des éléments de tressage différents formant la gaine.
- la gaine comprend autant de brins de détection que d'éléments de tressage.
- plusieurs brins de détection de la pluralité des brins de détection sont intégrés dans des éléments de tressage tressés dans un premier sens de rotation, et les autres brins de détection de la pluralité des brins de détection sont intégrés dans des éléments de tressage tressés dans un deuxième sens de de rotation opposé au premier sens de rotation.
- tous les brins de détection de la pluralité des brins de détection sont intégrés dans des éléments de tressage de la gaine tressés dans un même sens de rotation.
- chaque brin de détection est un fil électriquement conducteur entouré d'un élément tubulaire isolant électriquement.
- les brins de tressage des éléments de tressage de la gaine sont des fils électriquement conducteur, les différents éléments de tressage étant tressés pour former une gaine de protection électromagnétique des câbles.
- les brins de tressage des éléments de tressage de la gaine sont des fils textiles, les différents éléments de tressage étant tressés pour former une gaine de protection mécanique des câbles.

Selon un autre aspect, on propose un procédé de fabrication du dispositif de prédiction ci-dessus, caractérisé en ce qu'il comprend une étape de bobinage au cours de laquelle au moins un brin de détection est agencé avec une pluralité de brins de tressage pour former une nappe de tressage qui est mise en bobine, ladite nappe de tressage étant ensuite débobinée lors d'une étape de tressage pour former la gaine de protection autour d'un harnais formé d'une pluralité de câbles regroupés ensemble.

Selon encore un autre aspect, on propose un procédé de prédiction de la détérioration de câbles, en particulier de câbles électriques, regroupés pour former un harnais et entourés du dispositif de prédiction ci-dessus, comprenant l'application d'un courant électrique dans le au moins un brin de détection de la gaine de protection, et la surveillance du comportement électrique dudit brin de détection.

### DESCRIPTION DES FIGURES

D'autres caractéristiques et avantages de l'invention ressortiront encore de la description qui suit, laquelle est purement illustrative et non limitative et doit être lue en regard des dessins annexés, sur lesquels :
- la figure 1 est une représentation d'une gaine de protection destinée à entourer un harnais et formant le dispositif de prédiction selon l'invention ;
- la figure 2 est une représentation d'un motif de tressage pour la gaine de protection selon un premier mode de réalisation de l'invention ;
- la figure 3 est une représentation d'un motif de tressage pour la gaine de protection selon un deuxième mode de réalisation de l'invention ;
- la figure 4 est une représentation d'un motif de tressage pour la gaine de protection selon un troisième mode de réalisation de l'invention.

### DESCRIPTION DETAILLEE DE L'INVENTION

Comme indiqué plus haut, un harnais comprend un ensemble de câbles, notamment un ensemble de câbles électriques, qui sont seuls ou regroupés en sous-ensembles de câbles, appelés torons.

Un harnais est de préférence généralement entouré d'une gaine de protection, pouvant avoir une fonction de protection mécanique, et/ou une fonction de protection incendie, et/ou une fonction de protection électromagnétique par exemple.

La solution proposée pour anticiper l'apparition de défaut dans le harnais consiste à intégrer un système de détection de défaut au sein même de la gaine de protection. Ainsi, lorsque la gaine est contrainte au point de déclencher le système de détection qu'elle intègre, on sait qu'il faut agir pour éviter que la contrainte détectée ne vienne endommager les câbles formant le harnais.

L'avantage d'intégrer le système de détection au sein même de la gaine de protection est d'offrir un dispositif de prédiction de défauts qui ne vient pas substantiellement modifier le harnais et sa gaine de protection, notamment en termes de poids, ou de fonctionnement. Par ailleurs, cela n'impose pas de modification particulière dans l'utilisation du harnais entouré de sa gaine, ni dans sa conception.

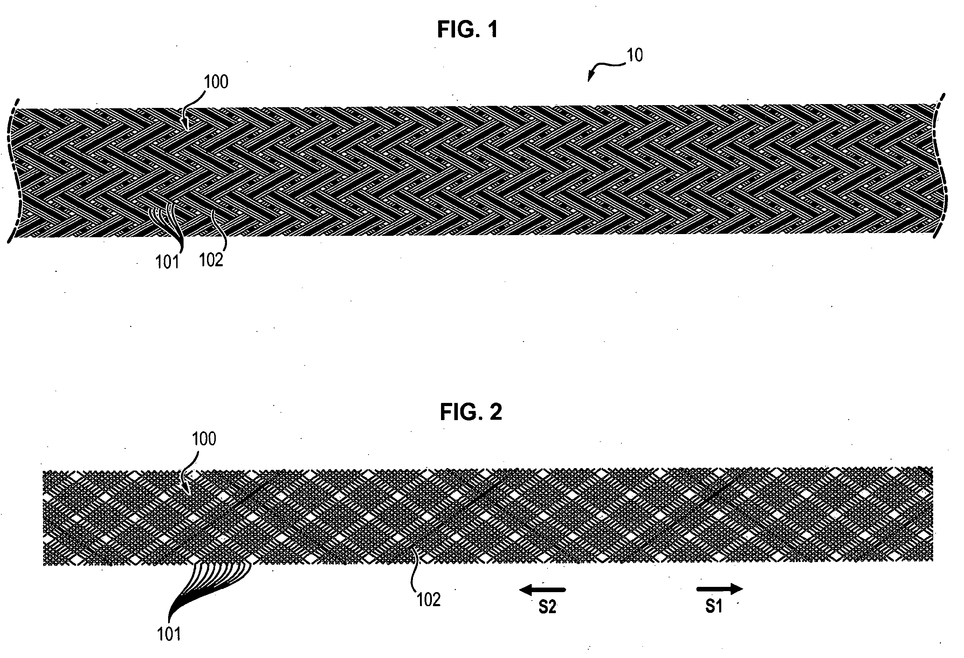

Comme on le voit représenté à la figure 1, les gaines de protection 10 utilisées pour entourer les harnais sont généralement formées d'une pluralité d'éléments de tressage 100, également appelés fuseaux, qui sont tressés ensemble de manière à former une gaine tubulaire, venant entourer le harnais destiné à être protégé.

Chaque élément de tressage 100 est constitué de plusieurs brins de tressage 101 qui sont agencés les uns à côté des autres, rendus solidaires, de manière à former une nappe.

Ces brins de tressage 101 sont généralement tous de même nature, identiques les uns aux autres, choisis en fonction de la finalité recherchée pour la gaine de protection.

Par exemple, si la gaine de protection a une fonction de protection mécanique ou incendie, voire de renforcement mécanique, les brins de tressage 101 peuvent être des fils dits textiles, des mono ou multifilaments de polymères, des fils en matière minérale (céramiques, verre amorphe ou non), ou des fils métalliques tels que des fils d'inox.

Lorsqu'une protection électromagnétique est recherchée, les éléments de tressage 100 sont préférentiellement formés de brins de tressage sous forme de fils électriquement conducteurs, qui sont agencés et tressés de manière à offrir cette fonction de protection électromagnétique. De tels fils conducteurs peuvent par exemple être des fils métalliques, tels que des fils de cuivre nickelé, des fils de cuivre argenté, des fils de cuivre étamé, des fils d'inox. Ces fils conducteurs sont agencés en nappes pour former les différents fuseaux 100, ces fuseaux étant tressés de manière à assurer une continuité électrique entre les câbles situés aux extrémités des harnais protégés par les gaines.

Pour permettre une prédiction de l'apparition de défauts dans les câbles formant le harnais, la gaine de protection comprend au moins un brin de détection 102 qui est conducteur électriquement, et qui présente la particularité d'être agencé avec les brins de tressage 101 d'au moins un des fuseaux 100 de la gaine 10, de manière à être totalement intégré à la nappe formant ce fuseau 100.

Le suivi de l'état de fonctionnement du brin de détection 102 permet ainsi de vérifier que la gaine n'est pas soumise à des contraintes trop importantes, qui pourraient se répercuter sur les câbles du harnais, et ainsi favoriser l'apparition de défauts.

En effet, lorsqu'une contrainte est appliquée sur la gaine 10, par exemple un frottement, et que cette contrainte vient endommager le fil de détection 102 de la gaine 10, la détection de cet endommagement permet d'en déduire que les câbles du harnais risquent d'être également endommagés si la contrainte perdure, et qu'il faut donc agir.

Le suivi de l'état de conductivité électrique du brin de détection 102 peut par exemple servir de base à la détection d'un endommagement dudit brin de détection 102. De préférence, pour permettre la prédiction et la détection grâce au brin de détection, le brin de détection 102 est isolé électriquement des brins de tressage 101 du fuseau 100 considéré. De préférence encore, le brin de détection 102 est également isolé des autres brins de tressage 101 des autres fuseaux 100 de la nappe 10.

Le brin de détection 102 peut par exemple être un fil électriquement conducteur entouré d'un élément tubulaire isolant électriquement, tel qu'un fil métallique émaillé, comme un fil de cuivre émaillé. Cela permet de garantir l'isolation du brin de détection 102 par rapport aux brins de tressage 101, voire par rapport à d'autres brins de détection prévus dans la gaine, comme on le verra plus loin.

Le brin de détection 102 peut aussi simplement consister en un fil électriquement conducteur, sans isolant complémentaire, mais dont l'isolation par rapport aux autres brins de tressage est effective, par exemple parce que ces brins de tressage sont des fils textiles, et/ou grâce à un agencement spécifique des brins de détection dans les fuseaux tressés.

Le brin de détection 102 peut aussi être un câble coaxial. Cela permet d'améliorer la détection de défauts, avec une détection plus précise de la localisation de tels défauts, notamment dans le cas d'utilisation de mesures de réflectométrie comme précisé ci-dessous.

La détection d'un endommagement du brin de détection 102 peut par exemple consister à faire parcourir un courant à travers ce brin de détection 102, et à surveiller son comportement électrique.

Une telle surveillance du comportement électrique du brin de détection 102 peut être réalisée avec des méthodes connues de l'homme du métier, telles que par exemple des mesures d'impédance, des mesures de capacité, des tests de coupures, ou autres. Pour une détection par mesure d'impédance, on peut par exemple mettre en court-circuit les brins de détection 102 à une extrémité du harnais, et connecter le dispositif de mesure d'impédance à l'autre extrémité des brins de mesures.

Une autre méthode préférée de surveillance du comportement électrique du brin de détection 102 consiste à effectuer des mesures de réflectométrie. On pourra par exemple utiliser une réflectométrie temporelle TDR (acronyme anglais de « Time Domain Reflectometry ») ou une réflectométrie fréquentielle FDR (acronyme anglais de « Frequency Domain Reflectometry »).

L'utilisation de méthodes de surveillance par réflectométrie est très avantageuse puisqu'elle permet non seulement de détecter que le brin de détection 102 est endommagé, mais également de localiser la position où ledit brin de détection 102 est endommagé. On peut donc en déduire à quel endroit le harnais pourrait être endommagé si la contrainte venait à être maintenue, et donc intervenir de façon plus ciblée sur le harnais. Ceci est particulièrement avantageux lorsque le harnais est placé dans des endroits difficiles d'accès.

Un autre avantage de l'utilisation de méthodes de surveillance par réflectométrie est qu'elles peuvent être utilisées sans venir perturber le comportement électromagnétique du harnais, et sans influence de la protection électromagnétique. Certaines méthodes de réflectométries permettent une maîtrise du niveau de tension, un étalement du spectre, ou d'autres paramétrages qui les rendent utilisables dans des conditions à fortes contraintes, notamment pour des véhicules en cours d'utilisation, tels que par exemples des aéronefs ou des navires où les contraintes électromagnétiques sont importantes.

Selon un mode de réalisation préféré la gaine comprend une pluralité de brins de détection 102, les brins de détection étant isolés électriquement les uns des autres. Le fait de multiplier les brins de détection 102 dans la gaine 10 permet d'avoir des zones de détection d'endommagement sur la gaine 10 qui sont plus nombreuses, et donc une probabilité de prédiction d'apparition de défauts sur le harnais plus importante. Il convient toutefois que le nombre de fils de détection 102 intégrés dans les nappes de tressage ne vienne pas ou peu modifier le comportement protecteur de la gaine 10, ou alourdir cette gaine 10. Par ailleurs, l'ajout d'au moins deux brins de détection, agencés en parallèle ou torsadés, permet d'effectuer une surveillance par détection différentielle.

De préférence, les différents brins de détections 102 sont intégrés dans des éléments de tressage 100 différents. Cela permet en effet de répartir de manière plus homogène et uniforme les zones de détection sur la gaine 10.

Par exemple, on peut prévoir une gaine 10 qui comprend autant de brins de détection 102 que d'éléments de tressage 100, ce qui permet d'avoir une détection accrue. Selon cet exemple, chaque élément de tressage 100 intègre un brin de détection 102 parmi les brins de tressage 101 formant la nappe à tresser.

Dans le cas où la gaine 10 comprend un nombre de brins de détection 102 plus grand que le nombre d'éléments de tressage 100, il y aura alors certains éléments de tressage intégrant plusieurs brins de détection 102. Cette configuration permet une détection accrue mais ne peut être envisagée que dans des cas où le fonctionnement protecteur de la gaine 10 n'est pas impacté par cette intégration d'un nombre important de brins de détection 102.

Lorsque la gaine 10 comprend plusieurs brins de détections 102, il est préférable que ces brins de détections 102 soient positionnées de manière à ne pas déséquilibrer l'équilibre générale de la gaine tubulaire.

Ainsi, les brins de détections 102 sont de préférence intégrés de façon répartie, à la fois dans des fuseaux 100 destinés à être tressés dans un sens de rotation par rapport à la direction de tressage (par exemple vers la droite) et dans des fuseaux 100 destinés à être tressés dans un sens de rotation opposé par rapport à la direction de tressage (par exemple vers la gauche).

De manière préférée encore, les brins de détections 102 sont intégrés dans des fuseaux 100 destinés à être tressés de façon sensiblement symétrique dans la gaine 10 de protection. Cela contribue au bon équilibrage de la gaine 10 par rapport au harnais.

Il pourrait également être envisagé que tous les brins de détection 102 soient intégrés dans des éléments de tressage de la gaine tressés dans un même sens de rotation. Cela est par exemple envisageable dans le cas d'une gaine tressée en tissu, c'est-à-dire formée de fuseaux 100 avec des fils textiles, dans laquelle on intègre des brins de détection 102 étant des fils électriquement conducteurs sans gaine d'isolation. Puisque les brins de détection 102 sont intégrés dans des fuseaux étant tous tressés dans le même sens de rotation, les brins de détection 102 ne viennent pas en contact les uns avec les autres, et la détection de défaut peut être opérée. Cela permet en outre d'utiliser des brins de détection dont le poids est réduit, évitant ainsi d'alourdir la gaine de protection.

Le nombre de brins de détection 102 à utiliser et leur agencement dans la gaine de protection sont adaptés en fonction notamment des conditions d'utilisation de la gaine, et du niveau de performance requise pour la gaine.

Par exemple, lorsque l'on réalise une gaine de protection électromagnétique, c'est-à-dire un blindage électromagnétique, on définit son impédance de transfert en fonction des contraintes électromagnétiques. Cette impédance de transfert est régie par différents paramètres comme le diamètre du harnais à protéger, l'angle de tressage des fuseaux 100 de la gaine 10, le nombre de fuseaux 100, le nombre de brins de tressage 101 par fuseau 100, le diamètre des brins de tressage 101 et la matière des brins de tressage. Comme le diamètre du harnais est imposé par les câbles contenus dans ledit harnais, on choisit les autres paramètres pour obtenir l'impédance de transfert souhaitée. On obtient alors une gaine tressée spécifique dans laquelle on peut remplacer ou ajouter un certain nombre de brins de tressage 101 par des brins de détection 102.

En général, une gaine tressée de protection électromagnétique a une performance réelle supérieure au gabarit à ne pas dépasser pour le harnais. De ce fait il est possible de profiter de cette marge entre la performance réelle de la tresse et le gabarit pour remplacer quelques brins de tressage par des brins de détection, ce qui va dégrader légèrement la performance de la gaine tressée sans pour autant qu'elle devienne inférieure à la performance requise par le gabarit. Dans le cas contraire il suffira d'ajouter le ou les brins de détection. Ceci nécessite de maîtriser la prédiction de la performance de la tresse, pour garantir le respect du gabarit imposé pour la fonction principale de la gaine de protection, tout en ajoutant une fonction de surveillance.

On peut aussi également dimensionner la gaine tressée en prenant non seulement en compte ses performances de protection, par exemple électromagnétique, mais également en considérant une performance de prédiction d'endommagement. Par exemple, il pourrait être envisagé de former la gaine tressée en intégrant que la surface endommageable du harnais ne doit pas être supérieure à 1 cm², et donc en ayant dans ce cas une portion de brin de détection au moins tous les 1 cm².

Les figures 2, 3, et 4 représentent différents motifs de gaines tressées ayant une surface de détection de plus en plus petite, et donc une performance de prédiction de plus en plus importante.

Les motifs illustrés aux figures 2, 3 et 4 correspondent à des gaines tressées constituées de 32 fuseaux tressés entre eux, à savoir 16 fuseaux tournant dans un premier sens S1 de rotation, et 16 fuseaux tournant dans un deuxième sens S2 de rotation, opposé à S1. Sur les figures, les 16 premiers fuseaux qui tournent dans le sens S1 tournent vers la droite par rapport au référentiel des figures, et les 16 autres fuseaux qui tournent dans le sens S2 tournent vers la gauche par rapport au référentiel des figures.

Sur les figures 2, 3, et 4, chaque fuseau 100 comprend 8 brins de tressage 101.

La gaine tressée dont le motif est représenté à la figure 2 comprend 8 brins de détection 102 venant chacun en remplacement d'un brin de tressage 101 d'un fuseau spécifique 100. La répartition est de 4 brins de détection dans des fuseaux qui tournent vers la droite et 4 brins de détection dans des fuseaux qui tournent vers la gauche, avec un brin de détection 102 maximum par fuseau 100. De manière préférée, comme illustré à la figure 2, on intègre un brin de détection 102 dans un fuseau 100 sur quatre dans un sens de rotation, ce qui permet de garantir une symétrie et un équilibre de la gaine tressée

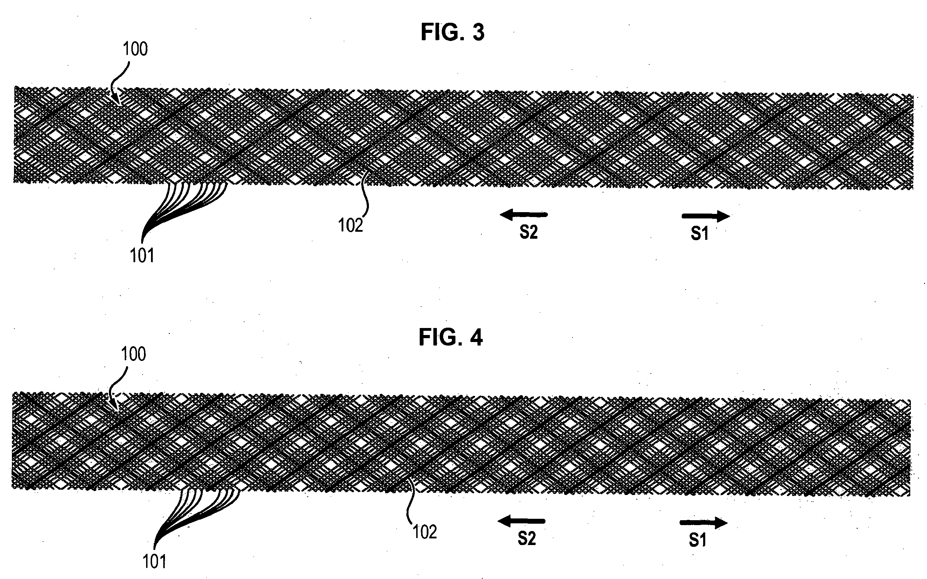

La gaine tressée dont le motif est représenté à la figure 3 comprend 16 brins de détection 102 venant chacun en remplacement d'un brin de tressage 101 d'un fuseau spécifique 100. La répartition est de 8 brins de détection dans des fuseaux qui tournent vers la droite et 8 brins de détection dans des fuseaux qui tournent vers la gauche, avec un brin de détection 102 maximum par fuseau 100. De manière préférée, comme illustré à la figure 3, on intègre un brin de détection 102 dans un fuseau 100 sur deux dans un sens de rotation, ce qui permet de garantir une symétrie et un équilibre de la gaine tressée.

La gaine tressée dont le motif est représenté à la figure 4 comprend 32 brins de détection 102 venant chacun en remplacement d'un brin de tressage 101 d'un fuseau spécifique 100. La répartition est de 16 brins de détection dans des fuseaux qui tournent vers la droite et 16 brins de détection dans des fuseaux qui tournent vers la gauche, avec un brin de détection 102 maximum par fuseau 100. Cet agencement est totalement symétrique et permet de garantir un équilibre de la gaine tressée.

Un exemple non limitatif d'utilisation du dispositif de prédiction proposé concerne la détection de défaut sans localisation. Ceci peut être le cas pour les harnais placés sur la jambe de train d'atterrissage où les harnais ne sont pas réparés mais changés en cas de détérioration. Dans ce cas, une mesure de résistance sur les brins de détection suffit. Les brins de détection sont alors connectés à la gaine de protection électromagnétique à une extrémité, et à un système de mesure de résistance à l'autre extrémité. La résistance mesurée dépend du nombre de brin de détection, de la longueur du brin de détection, de sa section, de sa résistivité, de la qualité du raccordement. La résistance peut varier à la hausse en cas de rupture d'un brin de détection en circuit ouvert et à la baisse en cas de rupture d'un brin de détection en court-circuit.

Un autre exemple non limitatif d'utilisation du dispositif de prédiction proposé concerne la détection de défaut avec localisation. Ceci peut être le cas pour des harnais réparables difficiles d'accès. L'utilisation de la localisation permet de démonter immédiatement le panneau derrière lequel se situe le défaut. Dans ce cas, les brins de détection n'ont pas besoin d'être connectés à la gaine tressée en extrémité du harnais, et la surveillance de dégradation des brins de détection se fait par une méthode de réflectométrie. De préférence, on n'effectue une telle surveillance par réflectométrie que sur un nombre limité de brins de détection simultanément, de manière à éviter les phénomènes de réflexion dus à la connexion parallèle des brins de détection.

Comme il ressort de ce qui précède, le dispositif de prédiction proposé est particulièrement avantageux dans son utilisation, Il présente en outre l'avantage de pouvoir être fabriqué de manière très simple, en ne modifiant que très légèrement les processus de fabrication existante pour les gaine de protection. En particulier, il suffit d'adapter l'étage de bobinage au cours de laquelle les brins de tressage sont généralement assemblés pour former la nappe de tressage constituant le fuseau, qui est ensuite mis en bobine. En effet, il suffit dans cette étape de bobinage de remplacer l'un des brins de tressage par un brin de détection, et de former la nappe de tressage.

Les différentes nappes de tressage, intégrant ou non des brins de détections, sont ensuite débobinées lors d'une étape de tressage pour former la gaine de protection autour du harnais à protéger.

Le lecteur aura compris que de nombreuses modifications peuvent être apportées sans sortir matériellement des nouveaux enseignements et des avantages décrits ici. Par conséquent, toutes les modifications de ce type sont destinées à être incorporées à l'intérieur de la portée de la gaine de protection présentée, de son procédé de fabrication et de son utilisation.

### REFERENCES BIBLIOGRAPHIQUES

- US 6,265,880

## Revendications

1. Dispositif de prédiction de défauts dans un harnais formé par une pluralité de câbles regroupés ensemble, en particulier des câbles électriques, comprenant une gaine (10) de protection destinée à entourer le harnais, la gaine (10) comprenant une pluralité d'éléments de tressage (100), lesdits éléments de tressage (100) étant tressés ensemble pour former une gaine tubulaire, chaque élément de tressage (100) comprenant une pluralité de brins de tressage (101) longitudinaux agencés pour former une nappe, **caractérisé en ce que** la gaine (100) comprend au moins un brin de détection (102) conducteur électriquement, ledit brin de détection (102) étant agencé avec les brins de tressage (101) d'un élément de tressage (100) pour être intégré à la nappe formant ledit élément de tressage (100), le brin de détection (102) étant isolé électriquement des brins de tressage (100) dudit l'élément de tressage (100).

2. Dispositif selon la revendication 1, dans lequel la gaine (10) comprend une pluralité de brins de détection (102), les brins de détection (102) étant isolés électriquement les uns des autres.

3. Dispositif selon la revendication 2, dans lequel les brins de détection (102) sont intégrés dans des éléments de tressage (100) différents formant la gaine (10).

4. Dispositif selon l'une quelconque des revendications 1 à 3, dans lequel la gaine (10) comprend autant de brins de détection (102) que d'éléments de tressage (100).

5. Dispositif selon l'une quelconque des revendications 2 à 4, dans lequel plusieurs brins de détection (102) de la pluralité des brins de détection (102) sont intégrés dans des éléments de tressage (100) tressés dans un premier sens de rotation (S1), et les autres brins de détection (102) de la pluralité des brins de détection (102) sont intégrés dans des éléments de tressage (100) tressés dans un deuxième sens de de rotation (S2) opposé au premier sens de rotation (S1).

6. Dispositif selon l'une quelconque des revendications 2 ou 3, dans lequel tous les brins de détection (102) de la pluralité des brins de détection (102) sont intégrés dans des éléments de tressage (100) de la gaine tressés dans un même sens de rotation.

7. Dispositif selon l'une quelconque des revendications 1 à 6, dans lequel chaque brin de détection (102) est un fil électriquement conducteur entouré d'un élément tubulaire isolant électriquement.

8. Dispositif selon l'une quelconque des revendications 1 à 7, dans lequel les brins de tressage (101) des éléments de tressage (100) de la gaine (10) sont des fils électriquement conducteur, les différents éléments de tressage (100) étant tressés pour former une gaine de protection électromagnétique des câbles.

9. Dispositif selon l'une quelconque des revendications 1 à 7, dans lequel les brins de tressage (101) des éléments de tressage (100) de la gaine (10) sont des fils textiles, les différents éléments de tressage (100) étant tressés pour former une gaine de protection mécanique des câbles.

10. Procédé de fabrication d'un dispositif de prédiction selon l'une quelconque des revendications 1 à 9, **caractérisé en ce qu'**il comprend une étape de bobinage au cours de laquelle au moins un brin de détection (102) est agencé avec une pluralité de brins de tressage (101) pour former une nappe de tressage (100) qui est mise en bobine, ladite nappe de tressage (100) étant ensuite débobinée lors d'une étape de tressage pour former la gaine de protection autour d'un harnais formé d'une pluralité de câbles regroupés ensemble.

11. Procédé de prédiction de la détérioration de câbles, en particulier de câbles électriques, regroupés pour former un harnais et entourés d'un dispositif de prédiction selon l'une quelconque des revendications 1 à 9, comprenant l'application d'un courant électrique dans le au moins un brin de détection (102) de la gaine de protection (10), et la surveillance du comportement électrique dudit brin de détection (102).

## Patentansprüche

1. Vorrichtung zur Vorhersage von Mängeln an einem Kabelbaum, der von einer Vielzahl zusammen gruppierter Kabel gebildet ist, insbesondere von elektrischen Kabeln, umfassend eine Schutzhülle (10), die bestimmt ist, den Kabelbaum zu umgeben, wobei die Hülle (10) eine Vielzahl von Flechtelementen (100) umfasst, wobei die Flechtelemente (100) zusammen geflochten sind, um eine schlauchförmige Hülle zu bilden, wobei jedes Flechtelement (100) eine Vielzahl von länglichen Flechtadern (101) umfasst, die ausgebildet sind, um eine Lage zu bilden, **dadurch gekennzeichnet, dass** die Hülle (100) mindestens eine elektrisch leitende Detektionsader (102) umfasst, wobei die Detektionsader (102) mit den Flechtadern (101) eines Flechtelements (100) ausgebildet ist, um in der Lage integriert zu sein, die das Flechtelement (100) bildet, wobei die Detektionsader (102) von den Flechtadern (100) des Flechtelements (100) elektrisch isoliert ist.

2. Vorrichtung nach Anspruch 1, wobei die Hülle (10) eine Vielzahl von Detektionsadern (102) umfasst, wobei die Detektionsadern (102) voneinander elektrisch isoliert sind.

3. Vorrichtung nach Anspruch 2, wobei die Detektionsadern (102) in unterschiedlichen Flechtelementen (100) integriert sind, die die Hülle (10) bilden.

4. Vorrichtung nach einem der Ansprüche 1 bis 3, wobei die Hülle (10) ebenso viele Detektionsadern (102) wie Flechtelemente (100) umfasst.

5. Vorrichtung nach einem der Ansprüche 2 bis 4, wobei mehrere Detektionsadern (102) der Vielzahl der Detektionsadern (102) in Flechtelementen (100) integriert sind, die in einer ersten Rotationsrichtung (S1) geflochten sind, und die anderen Detektionsadern (102) der Vielzahl der Detektionsadern (102) in Flechtelementen (100) integriert sind, die in einer zweiten Rotationsrichtung (S2) entgegengesetzt zur ersten Rotationsrichtung (S1) geflochten sind.

6. Vorrichtung nach einem der Ansprüche 2 oder 3, wobei alle Detektionsadern (102) der Vielzahl der Detektionsadern (102) in Flechtelementen (100) der Hülle integriert sind, die in einer selben Rotationsrichtung geflochten sind.

7. Vorrichtung nach einem der Ansprüche 1 bis 6, wobei jede Detektionsader (102) ein elektrisch leitender Draht ist, der von einem schlauchförmigen elektrisch isolierenden Element umgeben ist.

8. Vorrichtung nach einem der Ansprüche 1 bis 7, wobei die Flechtadern (101) der Flechtelemente (100) der Hülle (10) elektrisch leitende Drähte sind, wobei die unterschiedlichen Flechtelemente (100) geflochten sind, um eine elektromagnetische Schutzhülle der Kabel zubilden.

9. Vorrichtung nach einem der Ansprüche 1 bis 7, wobei die Flechtadern (101) der Flechtelemente (100) der Hülle (10) Textilfäden sind, wobei die unterschiedlichen Flechtelemente (100) geflochten sind, um eine mechanische Schutzhülle der Kabel zubilden.

10. Verfahren zur Herstellung einer Vorhersagevorrichtung nach einem der Ansprüche 1 bis 9, **dadurch gekennzeichnet, dass** es einen Wickelschritt umfasst, bei dem mindestens eine Detektionsader (102) mit einer Vielzahl von Flechtadern (101) ausgebildet ist, um eine Flechtlage (100) zu bilden, die gewickelt wird, wobei die Flechtlage (100) dann bei einem Flechtschritt abgewickelt wird, um die Schutzhülle um einen Kabelbaum zu bilden, der von einer Vielzahl von zusammen gruppierten Kabeln gebildet ist.

11. Verfahren zur Vorhersage der Beschädigung von Kabeln, insbesondere von elektrischen Kabeln, die gruppiert sind, um einen Kabelbaum zu bilden, und von einer Vorhersagevorrichtung nach einem der Ansprüche 1 bis 9 umgeben sind, umfassend die Anwendung eines elektrischen Stroms in der mindestens einen Detektionsader (102) der Schutzhülle (10) und die Überwachung des elektrischen Verhaltens der Detektionsader (102).

## Claims

1. A device for prediction of faults in a harness formed by a plurality of cables joined together, in particular electrical cables, comprising a protective sheath (10) intended to enclose the harness, the sheath (10) comprising a plurality of braiding elements (100), said braiding elements (100) being braided together to form a tubular sheath, each braiding element (100) comprising a plurality of longitudinal braiding strands (101) arranged to form a web, **characterized in that** the sheath (100) comprises at least one electrically conductive detection strand (102), said detection strand (102) being arranged with the braiding strands (101) of a braiding element (100) to be integrated into the web forming said braiding element (100), the detection strand (102) being electrically insulated from the braiding strands (100) of said braiding element (100).

2. The device according to claim 1, wherein the sheath (10) comprises a plurality of detection strands (102), the detection strands (102) being electrically insulated from each other.

3. The device according to claim 2, wherein the detection strands (102) are integrated into different braiding elements (100) forming the sheath (10).

4. The device according to any one of claims 1 to 3, wherein the sheath (10) comprises as many detection strands (102) as braiding elements (100).

5. The device according to any one of claims 2 to 4, wherein several detection strands (102) of the plurality of the detection strands (102) are integrated into braiding elements (100) braided in a first direction of rotation (S1), and the other detection strands (102) of the plurality of detection strands (102) are integrated into braiding elements (100) braided in a second direction of rotation (S2) opposite the first direction of rotation (S1).

6. The device according to any one of claims 2 or 3, wherein all the detection strands (102) of the plurality of detection strands (102) are integrated into braiding elements (100) of the sheath braided in the same direction of rotation.

7. The device according to any one of claims 1 to 6, wherein each detection strand (102) is an electrically conductive wire enclosed by an electrically insulating tubular element.

8. The device according to any one of claims 1 to 7, wherein the braiding strands (101) of the braiding elements (100) of the sheath (10) are electrically conductive wires, the different braiding elements (100) being braided to form a protective electromagnetic sheath of the cables.

9. The device according to any one of claims 1 to 7, wherein the braiding strands (101) of the braiding elements (100) of the sheath (10) are textile yarns, the different braiding elements (100) being braided to form a mechanical protective sheath of the cables.

10. A manufacturing method of a prediction device according to any one of claims 1 to 9, **characterized in that** it comprises a coiling step during which at least one detection strand (102) is arranged with a plurality of braiding strands (101) to form a braiding web (100) which is coiled, said braiding web (100) then being uncoiled during a braiding step to form the protective sheath around a harness formed by a plurality of cables joined together.

11. A prediction method of deterioration of cables, in particular of electrical cables, combined to form a harness and enclosed by a prediction device according to any one of claims 1 to 9, comprising application of electric current in the at least one detection strand (102) of the protective sheath (10), and monitoring of the electrical performance of said detection strand (102).
